**Europäisches Patentamt**

**European Patent Office**

**Office européen des brevets**

(11) Veröffentlichungsnummer: **0 103 255**
**A2**

(12) **EUROPÄISCHE PATENTANMELDUNG**

(21) Anmeldenummer: **83108758.0**

(22) Anmeldetag: **06.09.83**

(51) Int. Cl.³: **G 09 F 9/30,** G 09 F 9/37,
G 01 F 15/14, B 67 D 5/08

(30) Priorität: **11.09.82 DE 3233789**

(43) Veröffentlichungstag der Anmeldung: **21.03.84**
**Patentblatt 84/12**

(84) Benannte Vertragsstaaten: **AT BE CH DE GB IT LI NL**

(71) Anmelder: **Kienzle Apparate GmbH,**
**Heinrich-Hertz-Strasse, D-7730 Villingen-Schwenningen**
**(DE)**

(72) Erfinder: **Schelling, Hugo, Haselweg 10,**
**D-7730 Villingen-Schwenningen (DE)**
Erfinder: **Hummel, Dietmar, Wasenstrasse 9,**
**D-7730 Villingen-Schwenningen (DE)**

(54) **Mehrstellige elektrische Ziffernanzeigeeinrichtung, insbesondere zur Verwendung in Treibstoffzapfstellen.**

(57) Eine mehrstellige, elektrische Ziffernanzeigeeinrichtung (1) für die Anzeige von Mengen- und Preisangaben in Treibstoffzapfstellen besteht aus einer Mehrzahl elektrisch ansteuerbarer 7-Segment-Anzeigebausteine und einer elektronischen Steuerschaltung zur bistabilen Einstellung der ziffernbildenden Segmentelemente. Bei einer Verwendung in explosionsgefährdeter Umgebung, wie in Treibstoffzapfsäulen, sind höchste Anforderungen in bezug auf Sicherheit der elektrischen Bauteile solcher Einrichtungen einzuhalten. In Erfüllung derselben sind elektromagnetisch ansteuerbare Klappenanzeigebausteine (5) vorgesehen, deren bewegliche Bauteile (6) in einem quaderförmigen Gehäuse (7) untergebracht sind. Die Anzeigebausteine (5) sind gemeinsam mit allen Bauelementen (8 bis 14) der elektronischen Steuerschaltung auf einer Leiterplatte (15) angeordnet, die in eine einfache wannenförmige Form (17) einsetzbar ist, welche mit einem fließenden, nachhärtbaren Gießharz zu einem gasdichten Block (18) ausgießbar ist.

ACTORUM AG

0103255

10.09.1982
o73 sche zw
Akte 1787a

Kienzle Apparate GmbH, 7730 Villingen-Schwenningen

Mehrstellige elektrische Ziffernanzeigeeinrichtung, insbesondere zur Verwendung in Treibstoffzapfstellen

Die Erfindung bezieht sich auf eine mehrstellige Ziffernanzeigeeinrichtung zur Verwendung in explosionsgefährdeter Umgebung, insbesondere für die Anzeige von Mengen- und Preisangaben in Treibstoffzapfstellen, bestehend aus einer Mehrzahl elektrisch einstellbarer 7-Segment-Anzeigebausteine und einer elektronischen Steuerschaltung zur bistabilen Einstellung der ziffernbildenden Segmentelemente.

Zapfsäulen zur Abgabe von flüssigen Kraft- oder Brennstoffen sind aus der Praxis hinreichend bekannt. In der Regel bestehen sie aus einem stationär befestigten, schrankartigen Bauwerk, in welchem meist im Unterteil des Gehäuses zur Kraftstoff-Förderung aus einem Lagertank ein Kraftstoff-Förderaggregat, Filter, Gasabscheider, Durchflußmengenmeßgerät und Misch- und Regelvorrichtungen mit den notwendigen Leitungsverbindungen untergebracht sind. In der oberen Hälfte des Zapfsäulengehäuses sind die Zähl- und Rechengeräte, Bedienungs- und Überwachungsvorrichtungen sowie wenigstens eine, in der Regel aber zwei nach den Seiten angeordnete Anzeigevorrichtungen vorgesehen, die der Ablesung der bei einem Zapfvorgang entnommenen Mengeneinheiten des zu bezahlenden Preises dienen. Des weiteren ist im oberen Bereich einer Zapfsäule eine meist nischenartige Vorrichtung angeordnet, die der Aufnahme des Zapfventiles dient. Bei der Herausnahme des Zapfventiles werden gleichzeitig Steuerungsvorrichtungen ausgelöst, die in der Reihenfolge das Anzeigezählwerk automatisch nullstellen und anschließend den Pumpenmotor starten. Entsprechend wird beim Wiedereinhängen des Zapfventiles die Pumpe abgestellt und Steuerungsmittel in Vorbereitung für die Auslösung eines neuen Zapfvorganges ausgelöst. Zapfsäulen dieser Art werden seit langer Zeit mit mechanischen Rechenwerken, Zähl- und Anzeigegeräten ausgerüstet und haben sich im Bereich der explosionsgefährdeten Zonen bei Ausgabegeräten für Benzin- und Diesel-Treibstoffen an sich bewährt. Der Grund hierfür liegt darin, daß in der Umgebung des durch die fluide bzw. deren Dämpfe explosionsgefährdeten Raums fast ausschließlich mechanische Aggregate zur Anwendung kommen, so daß die strengen Vorschriften für Ausrüstungen in Verbindung mit gefährlichen Bezindämpfen auf einige wenige elektrische Bauteile beschränkt bleiben. Durch die wenig flexible Struktur der rein mechanischen Lösungen im Bereich der mechanischen Zähl-, Rechen- und Anzeigetechnik fehlt es bei diesen Aggregaten in zunehmendem Maße an den Variationsmöglichkeiten. Die schnell ansteigenden Preise auf dem Treibstoffsektor führen dazu, daß die Rechen- und Anzeigegetriebe auf immer höhere Drehzahlbereiche eingestellt werden müssen, so daß man schließlich an einer Grenze der Kapazität und Leistungsfähigkeit der bisherigen mechanischen Getriebe angelangt ist. Vor allem im Bereich der unteren Preisanzeigedekaden und entsprechend in bezug auf die begrenzt einstellbare Rechenfähigkeit der bisherigen Variatorgetriebe ist - bedingt durch die erhöhten Drehzahlen - eine Grenze erreicht, über die hinaus die exakte Funktionsweise aufgrund hoher Verschleißerscheinungen nicht mehr in gewohntem Maße gewährleistet werden kann. Während sich in der Gestaltung der Zumeßvorrichtungen einer Zapfsäule die Mechanik kaum ersetzen läßt und sich weiterhin behaupten wird, ist es angezeigt, im Rahmen einer Modernisierung die neue, inzwischen ausgereifte Technologie der Elektronik für die Zähl- und Rechentechnik anzuwenden. Hier erhebt sich unmittelbar das Problem, das gewährte Kraftstoffpumpensystem einer Zapfsäule mit der Elektronik für die Zähl- und Rechentechnik in möglichst kompakter Form in dem gewohnten Zapfsäulengehäuse zu kombinieren.

-3-

Das vollständige Ersetzen einer bestehenden Anlage wäre im höchsten Maße unwirtschaftlich und ließe sich auf dem Markt auch nicht vertreten. Andererseits jedoch bilden elektrische und elektronische Geräte bei der Anwendung in einer Umgebung mit evtl. entstehenden Kraftstoffdämpfen ein erhebiches Gefahrenmoment, so daß für den Einsatz von elektronischen Zähl- und Recheneinheiten in solchen Fällen strenge Auflagen hinsichtlich ihrer Ausbildung und Installation in Zapfsäulen zu beachten sind. Die elektronischen Zähler-, Anzeige- und Recheneinheiten einschl. der zugehörigen Ausrüstung für die Energieversorgung müssen infolgedessen entweder eigensicher konstruiert sein, was sehr teuer ist, oder sie müssen als von der Pumpe bezw. dem explosionsgefährdeten Raum selbst getrennte Einheit ausgebildet und angeordnet sein. Diese Auflagen stellen eine erhebliche Einschränkung für den Bereich der Fertigung von Zapfsäulen dar und machen eine Umstellung von älteren Zapfsäulen mit mechanischer Zähl- und Rechentechnik auf elektronische Baueinheiten am Aufstellungsort unmöglich. Die Maßnahmen für den Umbau der Säulengehäuse zur Erfüllung der Ex-Schutzvorschriften würden unvergleichbar hohe Kosten verursachen und erscheinen daher als nicht durchführbar.

Es ist eine Einrichtung zum Einbau elektrischer oder elektronischer Geräte in Vorrichtungen zur Abgabe von Kraft- oder Brennstoffen, wie beispielsweise an Tankstellen-Zapfsäulen der herkömmlichen Art, durch die DE-A 28 26 271 bekannt geworden. Die darin gezeigte Anordnung umfaßt ein druckdichtes Gehäuse zur Aufnahme der elektrischen oder elektronischen Geräte, Einrichtungen zum Aufbau eines Druckes im Innern des Gehäuses mit Hilfe eines Gases, vorzugsweise Luft, und einen druckempfindlichen Schalter innerhalb des Gehäuses, der so geschaltet ist, daß er die Stromversorgung zu den Geräten unterbricht, wenn der Druck in dem Gehäuse unter einen vorgegebenen Wert fällt. Die Wirksamkeit dieser Anordnung einer Art Fremdbelüftung liegt also darin, daß ein in dem Gehäuse aufgebauter und stets aufrechtzuerhaltender Überdruck das Eindringen von beispielsweise Benzindämpfen verhindert und auf diese Weise das Explosionsrisiko ausgeschlossen wird. Bei Abfall des Überdruckes durch ein Leck im Gehäuse oder ähnlichen Umständen muß der druckempfindliche Schalter die Anlage durch Stromabschaltung außer Betrieb setzen. Einmal braucht diese Anordnung eine ständig in Betrieb befindliche Luftdruckanlage mit einer Regeltechnik der Druckverhältnisse und ein entsprechend ausgedehntes Druckluftleitungssystem an jede Zapfsäule, was sicherlich mit erheblichen Aufwendungen für die Anlage und ständige Betriebsweise verbunden ist. Zum anderen muß das Gehäuse für Prüf- und Wartungsarbeiten an den hermetisch eingeschlossenen Geräten z. B. teilbar sein. Da Wartung und Prüfung wiederum nicht ohne Stromversorgung stattfinden können, muß zusätzlich für solche Fälle eine Überbrückungsschaltung der druckempfindlichen Schalter vorgesehen sein. Letztlich ist nach jeder Durchführung von Arbeiten wieder Sorge dafür zu tragen, daß das Gehäuse wieder druckluftdicht verschlossen und an das Druckluftaggregat angeschlossen ist. Diese Maßnahmen zusammengenommen sind nicht als optimale Lösung zu betrachten und erfordern zudem für sich selbst wiederum einen ständigen Betriebsaufwand und Wartung.

Weiter ist aus der DE-A 28 32 73o eine Anzeigeanordnung bekannt, bei der die 7-Segment-Anzeigemodulen in einem Gehäuse angeordnet sind, wobei das Gehäuse eine transparente Fläche hat, durch welche die Anzeigevorrichtung mit den 7 Segmenten gesehen werden kann, und aus zwei komplementären Halbmänteln oder Halbschalen zusammengesetzt ist, die durch Kleben miteinander verbunden werden. Zur Ansteuerung der Segmentanzeigemodulen ist zwischen den Halbmänteln des Gehäuses ein Schlitz bzw. eine Ausnehmung vorgesehen, durch welche das Flachbandkabel geführt und durch die Halbmäntel zusammengedrückt wird. Die Klebestellen zwischen den Halbmänteln des Gehäuses einschl. der Kabeldurchführung müssen gegen Benzindämpfe absolut dicht sein, so daß entsprechend der strengen Vorschrift eine Zündung von Gasgemischen aus dem Innern des Anzeigemoduls absolut verhindert wird. Die Anzeigemodule sind einzeln über flache, ummantelte Kabel mit einem weiteren flammensicheren Gehäuse, welches die elektronische Schaltung enthält, verbunden. Auch das zuletzt genannte Gehäuse muß den Ex-Schutzbestimmungen genügen und ist in sehr aufwendiger Weise als mehrteiliges Metall-Druckgußgehäuse ausgebildet. Sowohl die einzelnen Gehäuse für die Aufnahme der Anzeigevorrichtungen als auch das Gehäuse für die Umformelektronik sind fertigungsmäßig unvergleichbar teuer, und es ist bei beiden Gehäuseanordnungen höchste Sorgfalt darauf zu verwenden, die Klebestellen bzw. Gehäusefugen absolut druckfest bzw. gasdicht zu gestalten.

Aufgabe der Erfindung ist es, eine kompakte, mehrstellige, elektrisch ansteuerbare Ziffernanzeigeeinrichtung zur Verwendung in explosionsgefährdeter Umgebung insbesondere für Treibstoffzapfsäulen zu schaffen, die mit handelsüblichen 7-Segment-Anzeigebausteinen einschl. der hierzu erforderlichen elektrischen und elektronischen Ansteuerungsbausätze ausgerüstet ist und als kompakte Anzeigeeinheit leicht austauschbar ist.

Diese Aufgabe wird dadurch gelöst, daß als Anzeigemodule mehrere, in Reihen angeordnete Klappenanzeigebausteine vorgesehen sind, die einzeln ein die elektromagnetisch beweglichen Bauteile umgebendes, quaderförmig tiefgezogenes Gehäuse aufweisen und mit allen Bauelementen der elektronischen Steuerschaltung gemeinsam auf einer Leiterplatte angeordnet sind, dergestalt daß die vollständig bestückte Leiterplatte mit einer mehradrigen Steuerleitung versehen in eine einfache, wannenförmige Form einsetzbar und mit einem fließenden, nachhärtbaren Gießharz zu einem Block ausgießbar ist, derart daß sich alle elektrischen Bauteile und Anschlußverbindungen innerhalb einer gasdichten Vergußmasse befinden.

Weitere Merkmale zur Ausgestaltung der Erfindung sind den Unteransprüchen zu entnehmen.

Die Ziffernanzeigevorrichtung gemäß der Erfindung zeichnet sich dadurch aus, daß zu deren Aufbau durchweg handelsübliche Bausteine eingesetzt werden können, die als Einzelteile nicht den strengen Bauvorschriften für explosionsgeschützte Einrichtungen genügen müssen und schon deshalb auch viel billiger in der Herstellung sind. Bekanntlich besteht eine Anzeigeeinrichtung an Zapfsäulen aus drei unterschiedlichen, mehrstelligen Anzeigeinformationen, wovon beispielsweise eine fünfstellige Ziffer den für eine Entnahmemenge zu bezahlenden Preis angibt, darunter eine zweite fünfstellige Ziffer über die Entnahmemenge informiert und eine meist vierstellige Zahl schließlich Angaben macht über den der Preisberechnung zugrunde liegenden Preis je Mengeneinheit. Durch die Zusammensetzung der drei mehrstelligen Zahleninformationen aus Einzelbausteinen entsprechend den vorgeschlagenen Klappenanzeigebausteinen auf einer gemeinsamen Leiterplatte sind alle Möglichkeiten in bezug auf die Anordnung und die Kapazität der Anzeigeinformationen gegeben. Aufgrund der tief gezogenen Gehäuseform liegen die elektromagnetisch beweglichen Klappenelemente in einem gegen die mit elektrischen Bauelementen bestückte Leiterplatte abgekapselten Raum. Wählt man Bauelemente, die bezüglich ihrer Größe in Einbaulage unterhalb der Abdeckplatte der Anzeigebausteine bleiben, so erhält man die Möglichkeit, die voll bestückte Leiterplatte in einer einfachen, wannenförmigen Form mit Gießharz zu einem kompakten Block auszugießen, so daß sich alle elektrischen Bauteile einschl. der offenen Anschlußverbindungen innert einer gasdichten Vergußmasse befinden. Zu diesem Zweck wird die voll bestückte Leiterplatte mit Distanz-

0103255

pfosten in eine einfache Form eingelegt. Dadurch daß das Gehäuse der Klappenanzeigebausteine im Bereich der Spulenanschlüsse und vorzugsweise an den Schmalseiten, also entlang der Ober- und/oder Unterkante des Gehäuses Öffnungen aufweist, kann das Gießharz in den Spulenraum einfließen. Ist eine Füllhöhe erreicht, bei der die Spulenanschlüsse bzw. die Spulen selbst sich vollständig in Vergußmasse befinden, läßt man das Gießharz erstarren und kann anschließend den Raum außerhalb der Anzeigebausteine mit Vergußmasse ausfüllen, bis alle elektronischen Bauelemente mit Vergußmasse in geschlossener Schichtdicke überdeckt sind. Legt man die Füllgrenze für die Vergußmasse unterhalb der Frontdeckplatte der Anzeigebausteine, so läßt sich zum Schutz der Segmentklappen ein Schutzglas auf die überstehende Gehäusepartie aufstecken.

Eine derartige Anordnung kann ohne Bedenken an beliebiger Stelle in einer Zapfsäule angebracht werden. Sie eignet sich daher auch vorzüglich für einen Austausch und Ersatz der Zähleinrichtungen mechanischer Art in den bisherigen Zapfsäulen gegen Zähl- und Rechenaggregate in elektronischer Ausführungsform ohne einen erheblichen Umbau des Zapfsäulengehäuses in bezug auf Schutzmaßnahmen gegen die möglicherweise auftretenden Benzindämpfe vornehmen zu müssen. Die vollständig in einen Block aus Gießharz eingebettete Leiterplatte mit sämtlichen elektrischen und elektronischen Bauteilen und mit einer beispielsweise in einer S-Schleife durch eine dicke Schicht der Vergußmasse geführten mehradrigen Ansteuerleitung bietet die absolute Gewähr, daß eine entzündbare Gaskonzentration nicht bis in den Bereich der elektrischen Schaltungsanordnung vordringen kann. Ein Explosionsrisiko ist damit praktisch ausgeschlossen.

Ein Ausführungsbeispiel des Gegenstandes der Erfindung ist nachfolgend anhand der Zeichnungen beschrieben.

-8-

Es zeigt

FIG. 1 eine Draufsicht auf eine mehrstellige Ziffernanzeigeeinrichtung mit teilweisem Durchblick auf die
in das Gießharz eingebettete, bestückte Leiterplatte,

FIG. 2 eine Seitenansicht einer vollständigen Ziffernanzeigeeinrichtung, teilweise im Schnitt,

FIG. 3 einen Teilschnitt durch einen Klappenanzeigebaustein auf der bestückten Leiterplatte innert der
Vergußmasse.

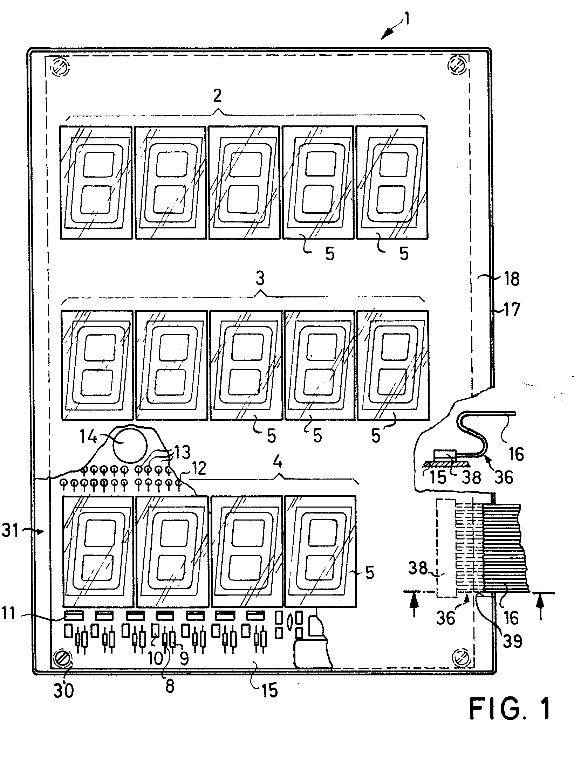

In den FIG. 1 bis 3 ist ein Ausführungsbeispiel der Erfindung
anhand eines praktischen Anwendungsfalles gezeigt. Die FIG. 1
stellt in einer Draufsicht eine komplette, mehrstellige Ziffernanzeigeeinrichtung 1 dar für die Anzeige von Mengen- und
Preisangaben in Treibstoffzapfstellen. In Anlehnung an die
Anordnungen der Anzeigeinformationen bei bekannten mechanischen Zapfsäulen sind in der Ansicht nach FIG. 1 zeilenförmig
von oben nach unten zwei fünfstellige Ziffernreihen 2 und 3
und eine vierstellige Ziffernreihe 4 vorgesehen. Die Ziffernreihe 2 dient der Angabe einer Information über den zu bezahlenden Preis für die bei einem Zapfvorgang erhaltene Treibstoffmenge. Die Ziffernreihe 3 gibt entsprechend die Entnahmemenge in Mengeneinheiten, beispielsweise in Litern, an.
Schließlich dient die vierstellige Ziffernreihe 4 der Anzeige
des geltenden Grundpreises je Mengeneinheit, z. B. des Preises in DM/l, der für die Berechnung des in der Ziffernreihe 2
angegebenen Gesamtpreises zur Anwendung gelangt. Für die Darstellung der einzelnen Ziffern hat sich im Zusammenhang mit
einer elektronischen Ansteuerung die Darstellungsform einer
Ziffer mit 7-Segment-Elementen eingeführt. Entsprechend gibt
es handelsüblich 7-Segment-Anzeigebausteine in unterschiedlicher Ausführungsform und Technologie. Für den speziellen Anwendungsfall in Zapfsäulen sind unter anderem der optische Effekt im Hinblick auf gute Lesbarkeit aus einiger Entfernung und die sichere Funktionsweise der ziffernbildenden Segmentelemente bei der Einstellung in eine der beiden stabilen Anzeigepositionen von entscheidender Bedeutung. Zur Verwirklichung der Anordnung gemäß der Erfindung sind als Ziffernanzeigemodule mehrere in Reihen 2, 3, 4 angeordnete Klappenanzeigebausteine 5 vorgesehen, die einzeln ein die elektromagnetisch beweglichen Bauteile 6 umgebendes, quaderförmig tiefgezogenes Gehäuse 7 aufweisen und mit allen Bauelementen 8 bis 14 der elektronischen Steuerschaltung gemeinsam auf einer Leiterplatte 15 angeordnet sind. Die vollständig bestückte Leiterplatte 15 ist mit einer mehradrigen Steuerleitung 16 versehen und wird in eine einfache, wannenförmige Form 17 eingesetzt, die mit einem fließenden, nachhärtbaren Gießharz zu einem Block 18 ausgegossen wird. Das Gehäuse 7 der Klappenanzeigebausteine 5 weist im Bereich der elektrischen Spulenanschlüsse 19, 2o, 21 an der Unterseite des Klappenanzeigebausteins 5 seitliche Öffnungen 22, 23, beispielsweise in Form von Aussparungen in der Wandung der Schmalseiten des Gehäuses 7 auf, durch die in einer ersten Füllphase Gießharz von der Rückseite in das Gehäuseinnere 24 einfließen kann. Das flüssige Gießharz kann über die seitlichen Öffnungen 22, 23 hinaus bis auf eine begrenzte Füllhöhe 25 ansteigen, bis maximal die Spulenwicklungen 27, 28, 29 zum Antrieb der beweglichen Bauteile 6 vollends in die Vergußmasse eingetaucht sind. Ist die durch die Anordnung der beweglichen Bauteile 6 der Klappenanzeigebausteine 5 begrenzte Füllhöhe 25 erreicht, so kann der Füllprozeß unterbrochen und eine Erstarrungsphase eingelegt werden, innerhalb welcher das flüssige Gießharz im Gehäuseinneren 24 eine starre Deckschicht bildet. Danach läßt sich der mit elektronischen Bauelementen bestückbare Raum 26 außerhalb der Anzeigebausteine 5 über die Füllhöhe 25 hinaus bis zu deren völligen Einbettung in die Vergußmasse auffüllen. Es ist aber auch im Sinne einer Begünstigung des Fertigungsablaufes möglich, daß das quaderförmig tiefgezogene Gehäuse 7 der Klappen-Anzeigebausteine 5 im Bereich der Spulenwicklungen 27, 28, 29 und der Spulenanschlußverbin-

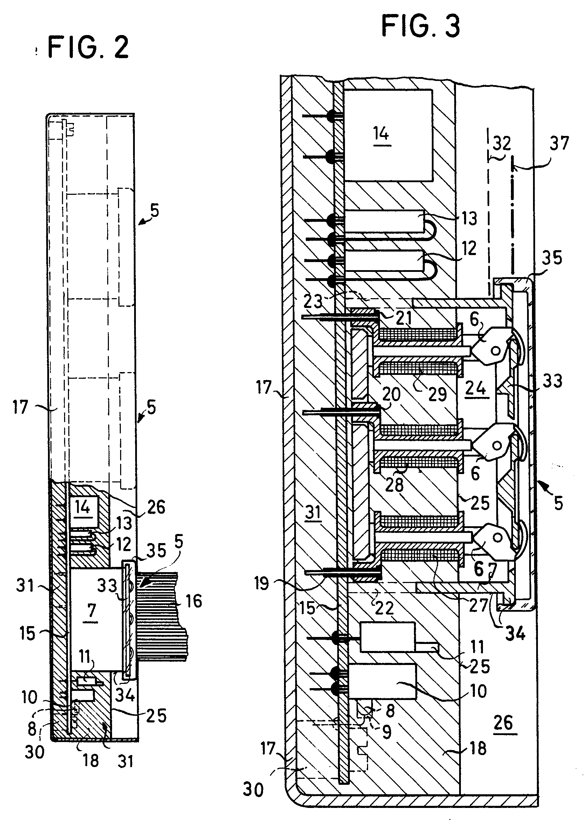

dungen 19, 2o, 21 vorab mit Vergußmasse ausgefüllt ist, so daß eine damit bestückte Leiterplatte 15 durchgängig zu einem Block 18 bis maximal auf eine Füllhöhe 37 in gleicher Ebene mit einer Frontabdeckplatte 33 des Gehäuses 7 ausgießbar ist (siehe FIG. 3). Bei der Auffüllung der Form 17 mit Gießharz muß gewährleistet sein, daß der gesamte Komplex von Bauteilen vollständig in das Gießharz eingebettet ist. Um dies zu erreichen, ist die voll bestückte Leiterplatte 15 mit Distanzpfosten 30 in die wannenförmige Form 17 einsetzbar, derart daß ein die Leiterplatte 15 und die elektrischen Bauelemente 8 bis 14 allseits umfassender Freiraum 31 entsteht, der mit Vergußmasse in geschlossener Schichtdicke zur Bildung eines gasdichten Blockes ausfüllbar ist. Die für das Gießen erforderliche Form 17 ist als einfach verwendbares, fünfwandiges Gehäuse beispielsweise aus Blech für die Aufnahme der gießfähigen Masse ausgebildet. Sie dient aber auch gleichzeitig als Verkleidungsteil des ausgehärteten Gießharz-Blockes 18 zum Schutz gegen mechanische Einflüsse von außen und erspart somit auch den Aufwand eines Rahmengestells zur Halterung der Anzeigeeinrichtung in der Gebrauchslage. In einer weiteren Ausbildungsform der Anzeigeeinrichtung ist vorgesehen, die Füllgrenze für die Vergußmasse außerhalb der Anzeigebausteine 5 auf eine Füllhöhe 32 unterhalb einer Frontdeckplatte 33 des Gehäuses 7 festzulegen, dergestalt daß auf die überstehende Gehäusepartie 34 der Anzeigebausteine 5 ein Schutzglas 35 aufsteckbar ist. Das transparente Schutzglas 35 verhindert das Eindringen von Staub und Schmutz in den Bereich der beweglichen Bauteile 6, die als Segmentelemente in ihrer Zusammensetzung die Ziffern bilden und gewährleistet damit eine störungsfreie Funktionsweise. Das Schutzglas verhindert aber auch eine direkte Einflußnahme auf die Einstellung der Segmentelemente, die leicht zu einer Zerstörung oder Fälschung der Ziffernanzeige führen könnte.

Die mehradrige Steuerleitung 16 zum Betrieb der Anzeigebausteine 5 ist, wie ausschnittsweise in FIG. 1 dargestellt ist, in einer Ausbildungsform eines resistenten Flachband-Mehrfachkabels vorgesehen und in einer beispielsweise S-förmigen Schleife 36 an die Leiterplatte 15 geführt, dergestalt daß sie auf lange Distanz in die Vergußmasse eingebettet ist. Entsprechend dieser Anordnung ist die Steuerleitung 16 nahe der Oberkante des gießfertigen Blockes 18 in eine entsprechende Aussparung 39 der Seitenwand in der Form 17 eingelegt und von oben nach unten in der S-förmigen Schleife 36 nahezu auf die volle Dicke des Blockes 18 in dem ausgießbaren Raum verteilt angeordnet und über eine Anschlußleiste 38 mit der Leiterplatte 15 verbunden. Durch diese Maßnahme erzielt man ohne Aufwand eine wirksame Absicherung gegen Zugbelastung. Des weiteren ist durch die auf lange Distanz erreichbare Einbettung der Steuerleitung 16 in die Vergußmasse wiederum ohne zusätzlichen Aufwand eine zuverlässige Abdichtung der Steuerleitungszuführung an die Leiterplatte 15 gewährleistet.

Patentansprüche:

1. Mehrstellige Ziffernanzeigeeinrichtung zur Verwendung in explosionsgefährdeter Umgebung, insbesondere für die Anzeige von Mengen- und Preisangaben in Treibstoffzapfstellen, bestehend aus einer Mehrzahl elektrisch einstellbarer 7-Segment-Anzeige-Bausteinen und einer elektronischen Steuerschaltung zur bistabilen Einstellung der ziffernbildenden Segmentelemente,

dadurch gekennzeichnet,

daß als Anzeigemodule mehrere in Reihen (2, 3, 4) angeordnete Klappenanzeigebausteine (5) vorgesehen sind, die einzeln ein die elektromagnetisch beweglichen Bauteile (6) umgebendes, quaderförmig tiefgezogenes Gehäuse (7) aufweisen und mit allen Bauelementen (8 bis 14) der elektronischen Steuerschaltung gemeinsam auf einer Leiterplatte (15) angeordnet sind, dergestalt daß die vollständig bestückte Leiterplatte (15) mit einer mehradrigen Steuerleitung (16) versehen in eine einfache, wannenförmige Form (17) einsetzbar und mit einem fließenden, nachhärtbaren Gießharz zu einem Block (18) ausgießbar ist, derart daß sich alle elektrischen Bauelemente (8 bis 14) und Anschlußverbindungen innerhalb einer gasdichten Vergußmasse befinden.

2. Mehrstellige Ziffernanzeigeeinrichtung nach Anspruch 1, dadurch gekennzeichnet,

daß das Gehäuse (7) der Klappenanzeigebausteine (5) im Bereich der elektrischen Spulenanschlüsse (19, 2o, 21) seitliche Öffnungen (22, 23) aufweist, die es gestatten, in einer ersten Füllphase Gießharz von der Rückseite in das Gehäuseinnere (24) einfließen und auf eine begrenzte Füllhöhe (25) ansteigen zu lassen, um schließlich nach einer Erstarrungsphase darüber hinaus den gesamten, mit elektronischen Bauelementen (8 bis 14) bestückbaren Raum (26) außerhalb der Anzeigebausteine (5) mit Vergußmasse auszufüllen.

3. Mehrstellige Ziffernanzeigeeinrichtung nach Anspruch 1,
dadurch gekennzeichnet,
daß das quaderförmig tiefgezogene Gehäuse (7) der Klappen-
Anzeigebausteine (5) im Bereich der Spulenwicklungen (27,
28, 29) und der Spulenanschlüsse (19, 2o, 21) vorab mit
Vergußmasse ausgefüllt ist, so daß eine damit bestückte
Leiterplatte (15) durchgängig zu einem Block (18) ausgießbar ist.

4. Mehrstellige Ziffernanzeigeeinrichtung nach den Ansprüchen 1 bis 3,
dadurch gekennzeichnet,
daß die voll bestückte Leiterplatte (15) mit Distanzpfosten (3o) in die wannenförmige Form einsetzbar ist, derart
daß ein die Leiterplatte (15) und elektrischen Bauelemente
(8 bis 14) allseits umfassender Freiraum (31) entsteht, der
mit Vergußmasse in geschlossener Schichtdicke zur Bildung
eines gasdichten Blockes (18) ausfüllbar ist.

5. Mehrstellige Ziffernanzeigeeinrichtung nach den Ansprüchen 1 und 4,
dadurch gekennzeichnet,
daß die wannenförmige Form (17) als einfach verwendbares,
fünfwandiges Gehäuse für die Aufnahme der gießfähigen Masse ausgebildet ist und gleichzeitig als Verkleidungsteil
des ausgehärteten Gießharz-Blockes (18) zum Schutz gegen
mechanische Einflüsse von außen dient.

6. Mehrstellige Ziffernanzeigeeinrichtung nach den Ansprüchen 1, 2 und 3,
dadurch gekennzeichnet,
daß die Füllgrenze für die Vergußmasse außerhalb der Anzeigebausteine (5) auf eine Füllhöhe (32) unterhalb einer Frontdeckplatte (33) festlegbar ist, dergestalt daß auf eine überstehende Gehäusepartie (34) der Anzeigebausteine (5) ein Schutzglas (35) aufsteckbar ist.

7. Mehrstellige Ziffernanzeigeeinrichtung nach Anspruch 1, dadurch gekennzeichnet, daß die Steuerleitung (16) zum Betrieb der Anzeigebausteine (5) in der Ausbildung eines resistenten Flachband-Mehrfachkabels vorgesehen und in einer Schleife (36) an die Leiterplatte (15) geführt ist, dergestalt daß sie auf lange Distanz in die Vergußmasse eingebettet und gegen Zugbelastung gesichert ist.

0103255

FIG. 1

FIG. 2

FIG. 3